# EUROPEAN PATENT SPECIFICATION

(11) **EP 0 343 215 B1**
(45) Date of publication and mention of the grant of the patent: **03.03.1993**
(21) Application number: 89900002.0
(22) Date of filing: 29.11.1988
(51) Int. Cl.: H03K 3/289

(54) **IMPROVEMENTS IN OR RELATING TO FLIP-FLOPS**
KIPPSCHALTUNGEN
AMELIORATIONS APPORTEES A DES BASCULES

(30) Priority: 30.11.1987 GB 8727953
(43) Date of publication of application: 29.11.1989
(73) Proprietor: PLESSEY SEMICONDUCTORS LIMITED, Swindon, Wiltshire SN2 2QW (GB)
(72) Inventor: COWLEY, Nicholas, Paul, Wiltshire (GB); LAWTON, Rod, Shaw Swindon Wiltshire (GB); McCLELLAND, Thomas, David, Stephen, Craigavon, Northern Ireland, BT62 2HF (GB)
(74) Representative: Nicholson, Ronald
(86) International application number: PCT/GB88/01043
(87) International publication number: WO 89/05546

(56) References cited:
- EP-A- 0 006 287
- US-A- 2 974 238
- US-A- 4 156 819
- D.J.McCarthy, "MOS device and circuit design", reprinted July 1983, John Wiley and Sons, pages 164,165,169

## Description

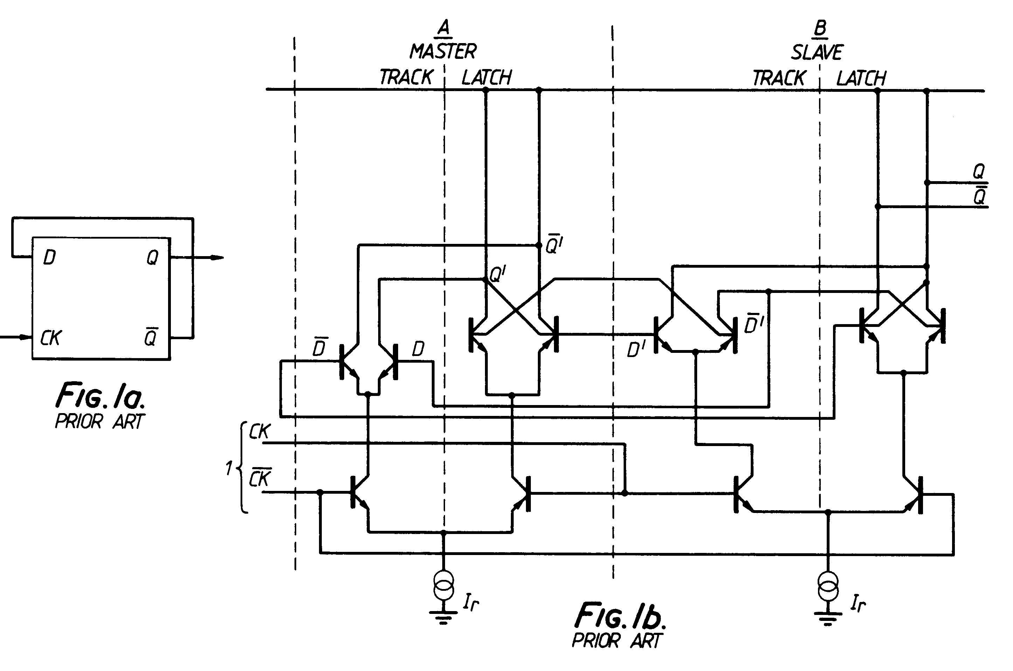

This invention relates to Flip-Flops, particularly D-Type Flip Flops. D-Type Flip-Flops can be used as divide-by-2 dividers in the configuration shown in Fig. 1a of the accompanying drawings. To prevent feed-through, such flip-flops are usually of the master-slave configuration in which the master is clocked on one edge of a clock pulse and the slave is clocked on the other edge. Thus, as shown in Fig.1a, a signal of a frequency Fₒ is fed to the clock input CK of the flip flop, the Q̅ output of the flip flop is connected to the D input, and the output, at a frequency of Fₒ /2 is taken from the Q output. The CK input may be fed directly to the master and through an invertor to the slave.

An integrated circuit realisation of such a master-slave D-type divide-by two flip-flop is shown in Fig 1B of the accompanying drawings. As seen in this figure, the master A comprises a tracking section and a latching section. Further both clock CK and inverted clock C̅K̅ inputs are shown. A clock CK input energises the tracking section of the slave B and the latch section of the master A to track values held in the latch section of the slave B onto the latch section of the master A. On a clock C̅K̅ input (the falling edge of an input clock pulse), the tracking section of the master A and the latch section of the slave B are energised to track values held in the latch A onto the latch B for output of the Q or Q̅ at half the input (clock) frequency. The appropriate flip-flop ports and interconnectors are indicated on the figure 1B.

A master slave flip-flop in which the master and slave flip-flops each include a tracking section and a latching section is disclosed for example in United States Patent No. 4,156,819.

Master slave flip-flops were introduced to prevent feed-through in which an input signal traversed the flip-flop in a sufficiently short time to feed back to the input and thereat to interfere with the input signal. However, the introduction of the latch sections of a master slave flip-flop reduced the operating speed in dependance upon the time taken for the latches to be powered up.

It is an object of the present invention to provide a master-slave flip-flop wherein the aforesaid disadvantage is overcome.

According to the present invention, there is provided a flip-flop comprising a master section and a slave section, wherein said master section and said slave section are non-latching sections and each section comprises a pair of transistors having their emitter electrodes connected together and to a collector electrode of one of a further pair of transistors the emitter electrodes of which are connected together and to a current source, antiphase clock signals being applied to the base electrodes of said further pair of transistors such that the pair of transistors of the master section and the pair of transistors of the slave section are enabled alternately, the collector electrodes of the said pairs of transistors having electrode capacitances and the pair of transistors of the slave section having their base electrodes arranged to be driven by remanent charges established on the electrode capacitances of respective collector electrodes of the pair of transistors of the master section, the base electrodes of the pair of transistors of the master section constituting respective input terminals of the flip-flops and the collector electrodes of the pair of transistors of the slave section constituting respective output terminals of the flip-flop.

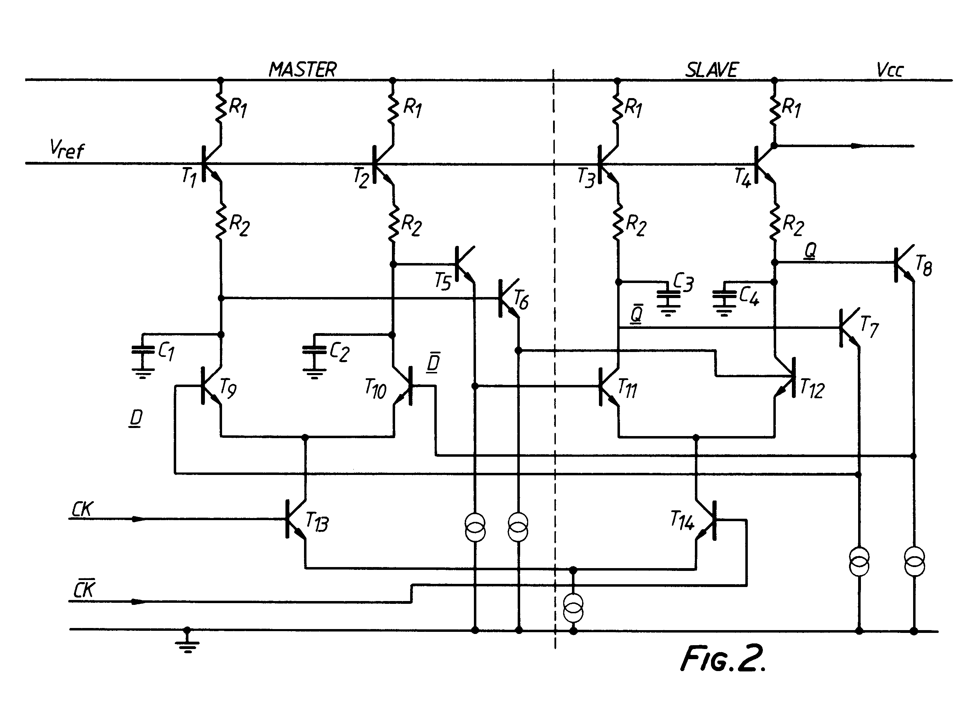

The invention will be described further, by way of example, with reference to Figure 2 of the accompanying drawings which illustrates a master-slave, D-type flip-flop arranged as a divide-by-two divider.

As shown in Figure 2, the frequency divider comprises a D-type Master-Slave flip-flop. A master section is powered up on clock pulses CK and the slave section is powered up on clock pulses CK (usually the falling edge of the input clock pulse). Each section is arranged only for tracking values through. No latch sections (as in the prior art) are provided. Upon power up, and the application of a clock pulse CK, transistor T₁₃ is switched on enabling either transistor T₉ or T₁₀ to be energised depending upon the base potential applied thereto. The base potentials of the transistors T₉ and T₁₀ are fed via the respective emitters of transistors T₇ and T₈ which, in turn, are energised in accordance with remanent charge (during operation) or circuit inbalance (initially) on the collectors of transistors T₁₁ and T₁₂.

The base of transistor T₁₀ is labelled the D̅ port of the flip-flop and, for a divide-by-two divider, is connected in known manner to the Q output of the flip-flop. The Q output is realised by the collector of the transistor T₁₂. In operation, the collector of transistor T₁₂ will hold thereon a remanent charge tracked thereto during the previous clock pulse C̅K̅. Similarly, the collector of the transistor T₁₁ will have an opposite remanent value thereon tracked during the previous clock pulse C̅K̅. These remanent values are dependant upon whether the transistor T₁₁ or the transistor T₁₂ was switched on which, in turn, depends upon the potential applied to the respective bases. The potential on the bases of transistors T₁₁ and T₁₂ are dependent upon the emitter voltage of transistors T₅ and T₆ which, in turn, depend upon remanent charges on the collectors of transistors T₉ and T₁₀ caused by the voltage thereat during the previously applied clock pulse CK.

It will be seen that each of the transistors T₉ to T₁₂ has a similar load circuit for establishing the appropriate voltage on their collectors. Each load circuit comprises a respective resistor R₁, a respective load transistor T₁ to T₄ and a respective resistor R₂.

It will be noted that a respective capacitor C₁ to C₄ is shown on the collector lead of each transistor T₉ to T₁₂. The capacitors C1 to C4 idealise the collector capacitance of the respective transistor. It has been found that, at high frequency clock pulse input, distinguishable

charge levels are held sufficiently long for each tracking section transistor to act also as a latch section transistor without the use of a separate latch section in the master or the slave. Thus, although no capacitors are actually provided, it has been found that the collector capacitance, in the circuit shown, suffices to replace completely, at high frequency inputs, the need for latching sections in the master and the slave. The transistors T₅ to T₈ enable these small remanent charges to drive the appropriate tracking transistors during the next clock pulse. The use of electrode and/or nodal capacitances to retain data values in logic circuits is discussed, for example, in "MOS Device and Circuit Design" by O.J.McCarthy, John Wiley & Sons Ltd., pp.164,165,169.

The invention is not confined to the precise details of the foregoing example and variations may be made thereto. For instance, depending upon the input frequency, the resistors R1, transistors T₁ to T₄ and resistors R₂ may be replaced by single resistors in the load circuit of the transistors T₉ to T₁2.

Similarly, a single clock input CK, followed by an invertor, may be used to provide both CK and C̅K̅ inputs.

In certain circumstances, the transistors T₅ to T₈ may be replaced by diodes.

In its use as a divide-by-2 divider, it matters not which way the circuit toggles on start up; the input frequency will be divided by two. However, appropriate bias may be provided to ensure that the ciruit is driven initially in a predetermined direction.

## Claims

1. A flip-flop comprising a master section and a slave section, wherein said master section and said slave section are non-latching sections and each section comprises a pair of transistors (T9, T10 and T11, T12) having their emitter electrodes connected together and to a collector electrode of one of a further pair of transistors (T13 and T14) the emitter electrodes of which are connected together and to a current source, antiphase clock signals being applied to the base electrodes of said further pair of transistors (T13 and T14) such that the pair of transistors (T9, T10) of the master section and the pair of transistors (T11, T12) of the slave section are enabled alternately, the collector electrodes of the said pairs of transistors (T9, T10, T11, T12) having electrode capacitances (C1, C2, C3, C4) and the pair of transistors (T11, T12) of the slave section having their base electrodes arranged to be driven by remanent charges established on the electrode capacitances (C1, C2) of respective collector electrodes of the pair of transistors (T9, T10) of the master section, the base electrodes of the pair of transistors (T9, T10) of the master section constituting respective input terminals (D, D̅) of the flip-flops and the collector electrodes of the pair of transistors (T11, T12) of the slave section constituting respective output terminals (Q, Q̅) of the flip-flop.

2. A flip-flop as claimed in Claim 1 characterised in that the base electrodes of the pair of transistors (T9, T10) of the master section are arranged to be driven by remanent charges established on the electrode capacitances (C3, C4) of respective collector electrodes of the pair of transistors (T11, T12) of the slave section, whereby the flip-flop acts as a divide-by-two frequency divider whose output is at half the frequency of the signal applied as the clock signal.

3. A flip-flop as claimed in Claim 1 or Claim 2 characterised in that respective base electrodes are arranged to be driven by the remanent charges established on the respective electrode capacitances (C1, C2, C3, C4) by way of respective emitter follower transistors (T5, T6, T7, T8).

## Patentansprüche

1. Flipflop enthaltend einen Master-Abschnitt und einen Slave-Abschnitt, bei dem der Master-Abschnitt und der Slave-Abschnitt nicht verriegelnde Abschnitte sind und jeder Abschnitt ein Paar Transistoren (T₉, T₁₀ und T₁₁, T₁₂) enthält, deren Emitterelektroden miteinander und mit einer Kollektorelektrode eines eines weiteren Paares Transistoren (T₁₃ und T₁₄) verbunden sind, deren Emitterelektroden miteinander und mit einer Stromquelle verbunden sind, gegenphasige Taktsignale an die Basiselektroden des weiteren Paares Transistoren (T₁₃ und T₁₄) derart gelegt sind, daß das Paar Transistoren (T₉, T₁₀) des Master-Abschnitts und das Paar Transistoren (T₁₁, T₁₂) des Slave-Abschnitts abwechselnd aktiviert werden, die Kollektorelektroden der genannten Paare Transistoren (T₉, T₁₀, T₁₁, T₁₂) Elektrodenkapazitäten (C₁, C₂, C₃, C₄) haben und das Paar Transistoren (T₁₁, T₁₂) des Slave-abschnitts mit seinen Basiselektroden so angeordnet ist, daß sie von an den Elektrodenkapazitäten (C₁, C₂) der jeweiligen Kollektorelektroden des Paares Transistoren (T₉, T₁₀) des Master-Abschnitts auftretenden remanenten Ladungen angesteuert werden, die Basiselektroden des Paares Transistoren (T₉, T₁₀) des Master-Abschnitts jeweilige Eingangsanschlüsse (D, D̅) des Flipflop bilden und die Kollektorelektroden des Paares Transistoren (T₁₁, T₁₂) des Slave-Abschnitts jeweilige Ausgangsanschlüsse (Q, Q̅) des Flipflop bilden.

2. Flipflop nach Anspruch 1,
**dadurch gekennzeichnet,**
daß die Basiselektroden des Paares Transistoren (T₉, T₁₀) des Master-Abschnitts derart angeordnet sind, daß sie von an den Elektrodenkapazitäten (C₃, C₄) der jeweiligen Kollektorelektroden des Paares Transistoren (T₁₁, T₁₂) des Slave-Abschnitts auftretenden remanenten Ladungen angesteuert werden, wodurch das Flipflop wie ein Teile-durch-2-Frequenzteiler wirkt, dessen Ausgangssignal die Hälfte der Frequenz des Signals hat, das als Taktsignal zugeführt wird.

3. Flipflop nach Anspruch 1 oder Anspruch 2,
**dadurch gekennzeichnet,**
daß jeweilige Basiselektroden so angeordnet sind, daß sie von den an den jeweiligen Elektrodenkapazitäten (C₁, C₂, C₃, C₄) auftretenden remanenten Ladungen über jeweilige Emitterfolgertransistoren (T₅, T₆, T₇, T₈) angesteuert werden.

## Revendications

1. Bascule comprenant une partie principale et une partie asservie, dans laquelle la partie principale et la partie asservie ne sont pas des sections de bascule et chaque partie comprend deux transistors (T9, T10 et T11, T12) dont les électrodes d'émetteurs sont connectées mutuellement et à une électrode de collecteur d'un transistor d'une paire supplémentaire de transistors (T13 et T14) dont les électrodes d'émetteurs sont connectées mutuellement et à une source de courant, des signaux d'horloge en opposition de phase étant appliqués aux électrodes de base des transistors de la paire supplémentaire (T13 et T14) afin que la paire de transistors (T9, T10) de la partie principale et la paire de transistors (T11, T12) de la partie asservie soient validées en alternance, les électrodes de collecteurs des paires de transistors (T9, T10, T11, T12) ayant des capacités d'électrodes (C1, C2, C3, C4) et la paire de transistors (T11, T12) de la partie asservie ayant des électrodes de base destinées à être pilotées par les charges restantes établies dans les capacités d'électrodes (C1, C2) des électrodes respectives de collecteurs de la paire de transistors (T9, T10) de la partie principale, les électrodes de base de la paire de transistors (T9, T10) de la partie principale constituant des bornes respectives d'entrée (D, D̅) des parties et les électrodes de collecteurs de la paire de transistors (T11, T12) de la partie asservie constituant des bornes respectives de sortie (Q, Q̅) de la bascule.

2. Bascule selon la revendication 1, caractérisée en ce que les électrodes de base de la paire de transistors (T9, T10) de la partie principale sont destinées à être pilotées par les charges restantes établies dans les capacités (C3, C4) des électrodes respectives de collecteurs de la paire de transistors (T11, T12) de la partie asservie, si bien que la bascule joue le rôle d'un circuit diviseur de fréquence à division par deux dont le signal de sortie est à la moitié de la fréquence du signal appliqué comme signal d'horloge.

3. Bascule selon la revendication 1 ou 2, caractérisée en ce que les électrodes respectives de base sont destinées à être pilotées par les charges restantes établies sur les capacités respectives d'électrodes (C1, C2, C3, C4) par l'intermédiaire des transistors respectifs à charge d'émetteur (T5, T6, T7, T8).
